# EUROPEAN PATENT APPLICATION

(11) **EP 4 672 342 A1**
(43) Date of publication of application: **31.12.2025**
(21) Application number: 23929990.2
(22) Date of filing: 24.11.2023
(51) Int. Cl.: H01L 31/048

(54) **FOLDING SOLAR PANEL**

(30) Priority: 28.03.2023 CN 202310314026
(71) Applicant: Shenzhen Hello Tech Energy Co., Ltd, Shenzhen, Guangdong 518109 (CN)
(72) Inventor: ZHU, Yanjun, Shenzhen, Guangdong 518109 (CN); SUN, Zhongwei, Shenzhen, Guangdong 518109 (CN); YU, Huajun, Shenzhen, Guangdong 518109 (CN); ZHANG, Minhuan, Shenzhen, Guangdong 518109 (CN)
(74) Representative: Dehns Germany Partnerschaft mbB
(86) International application number: PCT/CN2023/133985
(87) International publication number: WO 2024/198422

(57) **Abstract**

A foldable solar panel includes a power generation layer (100) and two adhesive film layers (200) located on two opposite sides of the power generation layer (100). The power generation layer (100) includes a plurality of sub-power generation panels (110) arranged at intervals and an interconnection wire (120). A bent region (2000) is formed in a gap between two adjacent sub-power generation panels (110). The two adjacent sub-power generation panels (110) are electrically connected by the interconnect wire (120) passing through the bent region (2000). An isolation layer (300) is arranged between the interconnect wire (120) and the adhesive film layer (200).

## Description

### CROSS-REFERENCE TO RELATED APPLICATION

This application claims a priority to and benefits from Chinese Patent Application No. 202310314026.2, filed with China National Intellectual Property Administration on March 28, 2023, the entire contents of which are incorporated herein by reference.

### FIELD

The present disclosure relates to the field of solar energy device technologies, and more particularly, to a foldable solar panel.

### BACKGROUND

A solar panel is an assembly assembled from a plurality of solar cells, and is the core part and the most important part of a solar power generation system.

To reduce a volume of a movable solar panel after storage and improve its portability, a foldable design is common for the movable solar panel. The foldable solar panel is usually provided with only one output terminal, and power generated by each sub-unit will be led to the output terminal through an electrical interconnection. In this way, wires of the electrical interconnection will surely pass through a folding region. When the solar panel is unfolded or stored, wires located in the folding region will be repeatedly unfolded and bent along with a folding part.

In a conventional foldable solar panel, adhesive films are arranged at an upper side and a lower side of the wires in the folding region. After the foldable solar panel is subjected to a high-temperature lamination process, the adhesive films melt and wrap the wires in the folding region or are immersed between the wires. Because the hardness of the hardened adhesive films is greater than the hardness of the wires, the flexibility of the wires is reduced, resulting in partial or complete broken of wires in a bent region after hundreds of bends. The partially broken wires will cause the resistance of the part of the wires to increase, resulting in serious local heat to burn through or fire the wires. The completely broken wires will cause the solar panel to produce an open circuit, and the solar panel will lose all or individual sub-unit electricity. In addition, wires crossing the bent region are easy to pierce packaging materials at two sides of the wires in a process of repeated bending, and the exposed wires are easy to cause electric shock accidents.

### SUMMARY

Based on the above descriptions, an objective of the present disclosure is to provide a foldable solar panel to prevent a hardened adhesive film layer from reducing the flexibility of an interconnection wire, and to enable a part of the interconnection wire in a bent region to be difficult to break, improving the durability of the interconnection wire. In addition, an isolation layer protects the interconnection wire and reduces a safety risk caused by the interconnection wire penetrating an outer packaging structure and being exposed.

To achieve the above objective, the present disclosure adopts the following technical solutions.

The foldable solar panel is provided. The foldable solar panel includes a power generation layer and two adhesive film layers stacked on front and back sides of the power generation layer, respectively. The power generation layer includes at least two sub-power generation panels and an interconnection wire. The at least two sub-power generation panels are arranged at intervals. A bent region is formed in a gap between two adjacent sub-power generation panels. The two adjacent sub-power generation panels are electrically connected by the interconnect wire passing through the bent region. An isolation layer is arranged between the interconnection wire and the adhesive film layer and at least covers a part of the interconnection wire located in the bent region, to isolate the part of the interconnection wire located in the bent region from the adhesive film layers at two sides of the interconnection wire.

As an optional technical solution for the foldable solar panel, the interconnection wire is movably arranged relative to the isolation layer and configured to move relative to the isolation layer in a radial and/or an axial direction. And/or the isolation layer is movably arranged relative to the adhesive film layer and configured to move relative to the adhesive film layer in a radial and/or axial direction.

As an optional technical solution for the foldable solar panel, the isolation layer has a sleeve-like structure. Two isolation layers are provided and arranged at two opposite sides of the interconnection wire, respectively.

As an optional technical solution for the foldable solar panel, an annular border element is arranged between the two isolation layers. Two side edges of the border element are sealingly connected to the two isolation layers respectively to form a barrier cavity. A first avoiding hole adapted to the interconnection wire is formed at each of two ends of the border element in an extending direction of the interconnection wire. The interconnection wire penetrates the barrier cavity via two first avoiding holes.

As an optional technical solution for the foldable solar panel, the isolation layer has a sleeve-like structure. The interconnection wire passes through a central through hole of the isolation layer.

As an optional technical solution for the foldable solar panel, two blocker are disposed at two ends of the isolation layer in an extending direction of the interconnection wire, respectively. The two blockers are configured to block two ends of the central through hole, respectively. Each of the two blockers has a second avoiding hole in communication with the central through hole. The second avoiding hole is adapted to the interconnection wire. The interconnection wire passes through the two second avoiding holes.

As an optional technical solution for the foldable solar panel, the isolation layer has a length in an extending direction of the interconnection wire greater than a width of the bent region in the extending direction of the interconnection wire. Two ends of the isolation layer in the extending direction of the interconnection wire overlap with the two adjacent sub-power generation panels at two sides of the isolation layer, respectively.

As an optional technical solution for the foldable solar panel, the isolation layer is made of an insulating material.

As an optional technical solution for the foldable solar panel, the interconnection wire has a flat structure. A width direction of the interconnection wire is perpendicular to a thickness direction of the foldable solar panel.

As an optional technical solution for the foldable solar panel, the foldable solar panel further includes two thin film layers. The two thin film layers are arranged at two sides of the two adhesive film layers away from the power generation layer, respectively. The two thin film layers are adhered to the power generation layer via the two adhesive film layers, respectively.

The present disclosure has the beneficial effects as follows.

According to the foldable solar panel provided by the present disclosure, the part of the interconnection wire located in the bent region is isolated from the two adhesive film layers at two sides of the interconnection wire by providing the isolation layer. Therefore, the adhesive film layers cannot be adhered to the interconnection wire in the bent region, thereby avoiding the flexibility of the interconnection wire being reduced by the hardened adhesive film layer. The part of the interconnection wire in the bent region can move freely when the foldable solar panel is folded, avoiding the interconnection wire being partially broken or completely broken and improving the durability of the interconnection wire. In addition, the isolation layer protects the interconnection wire and reduces the safety risk caused by the interconnection wire penetrating the outer packaging structure and being exposed, thereby improving the safety performance.

### BRIEF DESCRIPTION OF THE DRAWINGS

In order to clearly explain technical solutions in the embodiments of the present disclosure or in the related art, drawings used in the description of the embodiments or the related art are briefly described below. Obviously, the drawings as described below are merely some embodiments of the present disclosure. Based on these drawings, other drawings can be obtained by those skilled in the art without creative effort.
FIG. 1 is a schematic view of a structure of a foldable solar panel according to a first embodiment of the present disclosure.
FIG. 2 is a front view of a foldable solar panel according to a first embodiment of the present disclosure.
FIG. 3 is a schematic view of a stacked structure of a foldable solar panel according to a first embodiment of the present disclosure.
FIG. 4 is a schematic enlarged view of region A in FIG. 3.
FIG. 5 is a schematic view of a partial structure of a foldable solar panel according to a second embodiment of the present disclosure.
FIG. 6 is a schematic view of a partial structure of a foldable solar panel according to a third embodiment of the present disclosure.

### DETAILED DESCRIPTION

To make technical problems to be solved, technical solutions adopted, and technical effects achieved by the present disclosure clearer, the technical solutions according to embodiments of the present disclosure will be described in detail below in combination with accompanying drawings. Obviously, the embodiments described below are only a part of the embodiments of the present disclosure, rather than all of the embodiments. On a basis of the embodiments in the present disclosure, all other embodiments obtained by a person skilled in the art without creative labor shall fall within the protection scope of the present disclosure.

### First Embodiment

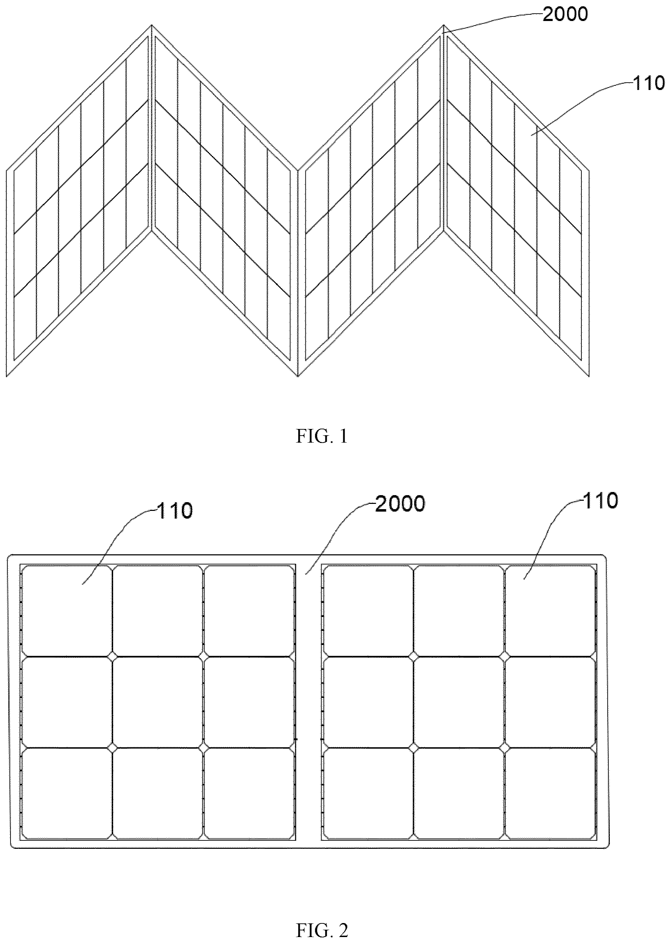

As shown in FIG. 1 to FIG. 4, this embodiment provides a foldable solar panel. The foldable solar panel includes a power generation layer 100, two adhesive film layers 200, and two thin film layers 600 that are staked. The two adhesive film layers 200 are arranged at two opposite sides of the power generation layer 100, respectively. The two thin film layers 600 are arranged at two sides of the two adhesive film layers 200 away from the power generation layer 100, respectively. The two thin film layers 600 and the power generation layer 100 are adhered via the two adhesive film layers 200, respectively. The power generation layer 100 includes at least two sub-power generation panels 110 and an interconnection wire 120. The sub-power generation panels 110 are electrically connected by the interconnection wire 120. Correspondingly, the foldable solar panel includes at least two power generation regions 1000 and a bent region 2000 arranged between adjacent power generation regions 1000. The sub-power generation panel 110 is located in the power generation region 1000. The sub-power generation panels 110 are arranged at intervals. The bent region 2000 is formed in a gap between adjacent sub-power generation panels 110. Adjacent sub-power generation panels 110 are electrically connected by the interconnection wire 120 passing through the bent region 2000.

In this embodiment, as shown in FIG. 1, the power generation layer 100 includes four sub-power generation panels 110 arranged in a straight line. The power generation regions 1000 are correspondingly provided with four in the straight line.

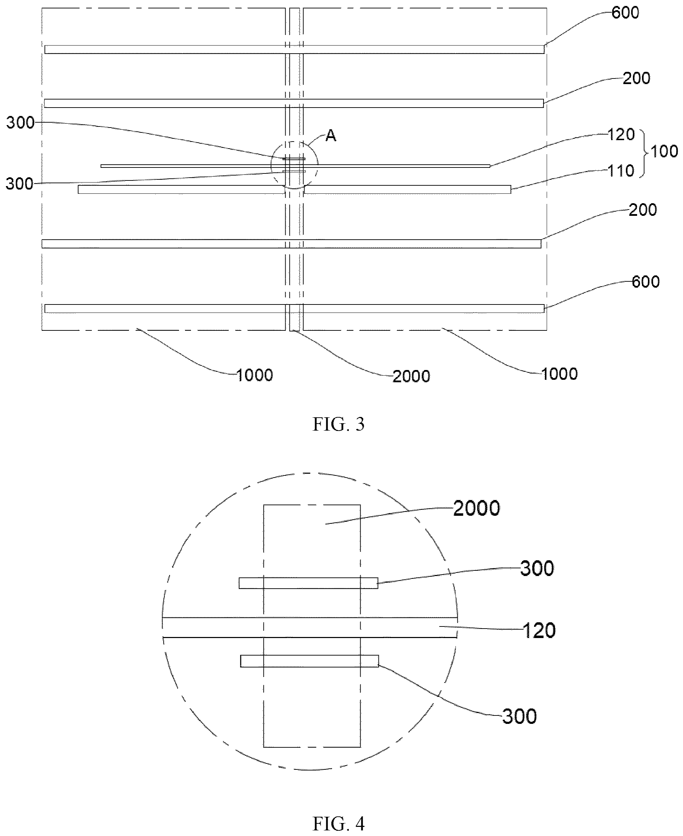

Further, as shown in FIG. 3 and FIG. 4, an isolation layer 300 is arranged between the interconnection wire 120 and the adhesive film layer 200. The isolation layer 300 at least covers a part of the interconnection wire 120 located in the bent region 2000, to isolate the part of the interconnection wire 120 located in the bent region 2000 from the adhesive film layers 200 at two sides of the interconnection wire 120.

In an exemplary embodiment of the present disclosure, according to the foldable solar panel provided by this embodiment, the part of the interconnection wire 120 located in the bent region 2000 is isolated from the two adhesive film layers 200 at two sides of the interconnection wire 120 by providing the isolation layer 300. Therefore, the adhesive film layers 200 cannot be adhered to the interconnection wire 120 in the bent region 2000, thereby avoiding the flexibility of the interconnection wire 120 being reduced by the hardened adhesive film layer 200. The part of the interconnection wire 120 in the bent region 2000 can move freely when the foldable solar panel is folded, avoiding the interconnection wire 120 being partially broken or completely broken and improving the durability of the interconnection wire 120. In addition, the isolation layer 300 protects the interconnection wire 120 and reduces a safety risk caused by the interconnection wire 120 penetrating an outer packaging structure and being exposed, thereby improving the safety performance.

As an example, the sub-power generation panel 110 is internally provided with a battery cell, a support frame, and packaging layers arranged at front and back sides of the battery cell, and the battery cell, the support frame, and the packaging layers are all hard structures and cannot be bent. In this embodiment, the support frame may be made of an epoxy glass fiber sheet and other materials, and the packaging layer may be made of a transparent PET (polyester resin) material. The packaging layer is adhered to the battery cell and the support frame by POE (polyolefin elastomer) adhesive film, PVB (polyvinyl butyral) adhesive film, and the like.

As an example, the sub-power generation panel 110 may include a plurality of battery cells. The battery cells are connected to each other in series and parallel with a connecting wire on the surface thereof by welding. The battery cells may be crystalline silicon battery cells or non-microcrystalline silicon battery cells. In an exemplary embodiment of the present disclosure, the battery cells may be PERC (Passivated Emitterand and Rear Cell) battery cells, N-type TOPCon (Tunneling Oxidation Passivation) battery cells, N-type HJT (Hereto-junction with Intrinsic Thin-layer) battery cells, IBC (Interdigitized back contact) battery cells or HPBC (Composite Passivation Back Contact) battery cells.

As an example, the interconnection wire 120 has a flat structure. A width direction of the interconnection wire 120 is perpendicular to a thickness direction of the foldable solar panel. By increasing a width of the interconnection wire 120 and decreasing a thickness of the interconnection wire 120, a deformation amount of the interconnection wire 120 during bending is reduced, and the tolerance of the interconnection wire 120 to a bending action is increased. In this way, a risk of breakage of the interconnection wire 120 is further reduced.

As an example, the interconnection wire 120 uses a braided copper wire and has good stretch properties.

As an example, as shown in FIG. 3, the adhesive film layers 200 and the thin film layers 600 are provided throughout each power generation layer 100 and a bent layer. In the power generation region 1000, front and back sides of the sub-power generation panel 110 are adhered to the corresponding thin film layers 600 through the adhesive film layers 200 at high temperature and high pressure, respectively. In the bent region 2000, two adhesive film layers 200 are adhered between the two adhesive film layers 200 through the adhesive film layers 200 at high temperature and high pressure.

As an example, the adhesive film layer 200 may adopt one or more among the POE adhesive film, an EVA (ethylene vinyl acetate copolymer) adhesive film, and the PVB adhesive film. For example, the adhesive film layer 200 adopts the EVA adhesive film, which has good durability.

As an example, the interconnection wire 120 is movably arranged relative to the isolation layer 300, i.e., no fixed structure is arranged between the interconnection wire 120 and the isolation layer 300. Therefore, the interconnection wire 120 can move relative to the isolation layer 300 in a radial direction and/or an axial direction to ensure movement freedom of the interconnection wire 120. The interconnection wire 120 can move relative to the isolation layer 300 when the foldable solar panel is folded or unfolded, thereby having a greater movement range and further reducing a risk of the interconnection wire 120 being broken.

For example, the isolation layer 300 is movably arranged relative to the adhesive film layer 200, i.e., the isolation layer 300 is not fixed to the adhesive film layer 200 by adhering or other means. The isolation layer 300 can move relative to the adhesive film layer 200 in a radial and/or an axial direction to ensure movement freedom of the interconnection wire 120 in the isolation layer 300. The interconnection wire 120 can move relative to the adhesive film layer 200 when the foldable solar panel is folded or unfolded, thereby having a greater movement range and further reducing the risk of the interconnection wire 120 being broken. In an exemplary embodiment of the present disclosure, this arrangement can be realized by arranging a window structure at a position corresponding to the isolation layer 300 on the adhesive film layer 200. Further, in order to avoid exposure of the isolation layer 300, a shielding layer made of a material without adhesion such as nylon may be arranged on the window structure to cover the window structure.

For example, a length of the isolation layer 300 in an extending direction of the interconnection wire 120 is greater than a width of the bent region 2000. Two ends of the isolation layer 300 in the extending direction of the interconnection wire 120 overlap with the two adjacent sub-power generation panels 110 at two sides of the isolation layer 300, respectively. On the one hand, the isolation layer 300 can be ensured to completely cover the interconnection wire 120 in the bent region 2000, improving the reliability of isolating the adhesive film layer 200. On the other hand, the isolation layer 300 can lap-joint on the sub-power generation panel 110 at two ends when assembling the foldable solar panel, which facilitates the positioning and fixing of the isolation layer 300, and improves assembly efficiency and a fault tolerance rate of the foldable solar panel.

As an example, as shown in FIG. 3 and FIG. 4, the isolation layer 300 has a layered structure, and two isolation layers 300 are provided. The two isolation layers 300 are arranged at two opposite sides of the interconnection wire 120, respectively.

As an example, the isolation layer 300 is made of an insulating material.

As an example, the isolation layer 300 is made of an insulating material having high mechanical toughness, such as an ultra-thin PET (polyethylene terephthalate) film having a thickness between 50 µm and µ m, PVC (polyvinyl chloride), silicone, and the like.

Bending tests are performed on the foldable solar panel without the isolation layer 300 and the foldable solar panel of this embodiment, respectively. When the foldable solar panel without the isolation layer 300 is bent more than 200 times, a resistance is significantly increased. When the bending is more than 400 times, the foldable solar panel generates leakage, and when the bending reaches 1200 times, the wire is broken. However, after the foldable solar panel using the isolation layer 300 of this embodiment is bent for 3600 times, there is still no increase in resistance, broken of the interconnection wire 120 or exposure of the interconnection wire 120, and a bending resistance and a safety performance of the interconnection wire 120 are significantly improved.

### Second Embodiment

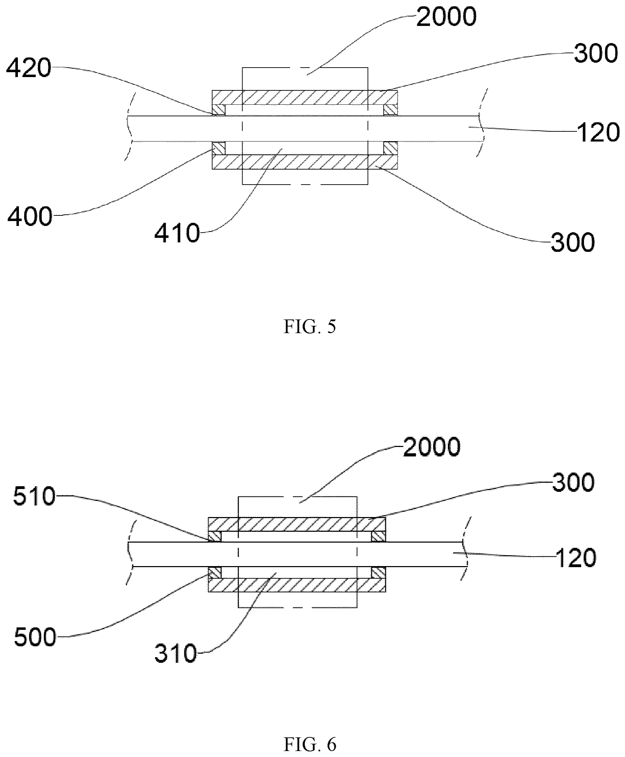

As shown in FIG. 5, on the basis of the first embodiment, this embodiment provides another foldable solar panel, which differs from the first embodiment as follows.

An annular border element 400 is arranged between the two isolation layers 300. Two side edges of the border element 400 are sealingly connected to the two isolation layers 300 respectively to form a barrier cavity 410. A first avoiding hole 420 adapted to the interconnection wire 120 is formed at each of two ends of the border element 400 in an extending direction of the interconnection wire 120. The interconnection wire 120 penetrates the barrier cavity 410 via two first avoiding holes 420.

In an exemplary embodiment of the present disclosure, an arrangement of the border element 400 can reduce penetration of an adhesive of the adhesive film layer 200 into a space between the two isolation layers 300 from an end of the isolation layer 300, thereby preventing the penetrated adhesive from adhering to the interconnection wire 120 or between the interconnection wire 120 and the isolation layer 300. In this way, flexibility and a movement space for the interconnection wire 120 are not affected, which in turn ensures that the interconnection wire 120 remains flexible and has sufficient movement space to improve reliability.

As an example, an inner diameter of the first avoiding hole 420 is equal to an outer diameter of the interconnection wire 120. An inner wall of the first avoiding hole 420 is sealingly connected to the interconnection wire 120, thereby further preventing the adhesive of the adhesive film layer 200 from penetrating into the barrier cavity 410, and having higher reliability.

As an example, two isolation layers 300 are integrally formed with the border element 400.

### Third Embodiment

As shown in FIG. 6, on the basis of the first embodiment, this embodiment provides another foldable solar panel, which differs from the first embodiment as follows.

The isolation layer 300 has a sleeve-like structure. The interconnection wire 120 passes through a central through hole 310 of the isolation layer 300. The isolation layer 300 is arranged around the interconnection wire 120 before the interconnection wire 120 connects to the two sub-power generation panels 110. In this way, a structure of the foldable solar panel is simple and convenient for production.

As an example, an inner diameter of the central through hole 310 is greater than the outer diameter of the interconnection wire 120 to ensure that the interconnection wire 120 has sufficient movement space within the central through hole 310.

As an example, two blockers 500 are disposed at two ends of the isolation layer 300 in an extending direction of the interconnection wire 120, respectively. The two blockers 500 are configured to block two ends of the central through hole 310, respectively. Each of the two blockers 500 has a second avoiding hole 510 in communication with the central through hole 310. The second avoiding hole 510 is adapted to the interconnection wire 120. The interconnection wire 120 passes through the two second avoiding holes 510.

In an exemplary embodiment of the present disclosure, an arrangement of the two blockers 500 can reduce penetration of the adhesive of the adhesive film layer 200 into the two central through holes 310 from the end of the isolation layer 300, thereby preventing the penetrated adhesive from adhering to the interconnection wire 120 or between the interconnection wire 120 and the isolation layer 300. In this way, the flexibility and the movement space for the interconnection wire 120 are not affected, which in turn ensures that the interconnection wire 120 remains flexible and has sufficient movement space to improve reliability.

As an example, an inner diameter of the second avoiding hole 510 is equal to the outer diameter of the interconnection wire 120. An inner wall of the second avoiding hole 510 is sealingly connected to the interconnection wire 120, thereby further preventing the adhesive of the adhesive film layer 200 from penetrating into the central through hole 310, and having higher reliability.

As an example, the isolation layer 300 is integrally formed with the blocker 500.

Note that the above is only preferred embodiments of the present disclosure and the technical principles used. Those skilled in the art will appreciate that the present disclosure is not limited to the specific embodiments described herein. Various obvious variations, readjustments, and substitutions can be made by those skilled in the art without departing from the protection scope of the present disclosure. Therefore, although the present disclosure has been described in more detail by the above embodiments, the present disclosure is not limited to the above embodiments, and may further include more equivalent embodiments without departing from the conception of the present disclosure. The scope of the present disclosure is determined by the scope of the appended claims.

## Claims

1. A foldable solar panel, comprising:
a power generation layer (100), wherein the power generation layer (100) comprises at least two sub-power generation panels (110) and an interconnection wire (120), the at least two sub-power generation panels (110) being arranged at intervals, a bent region (2000) being formed in a gap between two adjacent sub-power generation panels (110) of the at least two sub-power generation panels (110), and the two adjacent sub-power generation panels (110) being electrically connected by the interconnect wire (120) passing through the bent region (2000); and
two adhesive film layers (200) stacked on two opposite sides of the power generation layer (100), respectively, wherein an isolation layer (300) is arranged between the interconnect wire (120) and the adhesive film layer (200), the isolation layer (300) at least covering a part of the interconnect wire (120) located in the bent region (2000), to isolate the part of the interconnection wire (120) located in the bent region (2000) from the adhesive film layer (200) at two sides of the interconnection wire (120).

2. The foldable solar panel according to claim 1, wherein:
the interconnection wire (120) is movably arranged relative to the isolation layer (300) and configured to move relative to the isolation layer (300) in a radial and/or an axial direction; and/or
the isolation layer (300) is movably arranged relative to the adhesive film layer (200) and configured to move relative to the adhesive film layer (200) in a radial and/or axial direction.

3. The foldable solar panel according to claim 1, wherein:
the isolation layer (300) has a layered structure; and
two isolation layers (300) are provided and arranged at two opposite sides of the interconnection wire (120), respectively.

4. The foldable solar panel according to claim 3, wherein:
an annular border element (400) is arranged between the two isolation layers (300), two side edges of the border element (400) being sealingly connected to the two isolation layers (300) respectively to form a barrier cavity (410); and
a first avoiding hole (420) adapted to the interconnection wire (120) is formed at each of two ends of the border element (400) in an extending direction of the interconnection wire (120), the interconnection wire (120) penetrating the barrier cavity (410) via two first avoiding holes (420).

5. The foldable solar panel according to claim 1, wherein:
the isolation layer (300) has a sleeve-like structure; and
the interconnection wire (120) passes through a central through hole (310) of the isolation layer (300).

6. The foldable solar panel according to claim 5, wherein:
two blockers (500) are disposed at two ends of the isolation layer (300) in an extending direction of the interconnection wire (120), respectively, the two blockers (500) being configured to block two ends of the central through hole (310), respectively; and
each of the two blockers (500) has a second avoiding hole (510) in communication with the central through hole (310), the second avoiding hole (510) being adapted to the interconnection wire (120), and the interconnection wire (120) passing through the two second avoiding holes (510).

7. The foldable solar panel according to any one of claims 1 to 6, wherein:
the isolation layer (300) has a length in an extending direction of the interconnection wire (120) greater than a width of the bent region (2000) in the extending direction of the interconnection wire (120); and
two ends of the isolation layer (300) in the extending direction of the interconnection wire (120) overlap with the two adjacent sub-power generation panels (110) at two sides of the isolation layer (300), respectively.

8. The foldable solar panel according to any one of claims 1 to 6, wherein the isolation layer (300) is made of an insulating material.

9. The foldable solar panel according to any one of claims 1 to 6, wherein:
the interconnection wire (120) has a flat structure; and
a width direction of the interconnection wire (120) is perpendicular to a thickness direction of the foldable solar panel.

10. The foldable solar panel according to any one of claims 1 to 6, further comprising two thin film layers (600), wherein:
the two thin film layers (600) are arranged at two sides of the two adhesive film layers (200) away from the power generation layer (100), respectively; and
the two thin film layers (600) are adhered to the power generation layer (100) via the two adhesive film layers (200), respectively.
